# EUROPÄISCHE PATENTSCHRIFT

(11) **EP 0 647 089 B1**
(45) Veröffentlichungstag und Bekanntmachung des Hinweises auf die Patenterteilung: **25.03.1998**
(21) Anmeldenummer: 94114451.1
(22) Anmeldetag: 14.09.1994
(51) Int. Cl.: H05K 3/38, C23C 14/02

(54) **Verfahren zur Herstellung von dreidimensionalen Kunststoffteilen mit integrierten Leiterzügen**
Process for the manufacture of three dimensional plastic parts having integrated conductive tracks
Procédé de fabrication de pièces tridimensionelles en matière plastique à lignes conductrices intégrées

(30) Priorität: 30.09.1993 DE 4333414
(43) Veröffentlichungstag der Anmeldung: 05.04.1995
(73) Patentinhaber: SIEMENS AKTIENGESELLSCHAFT, 80333 München (DE)
(72) Erfinder: Denys, Wilfried, B-08310 Brugge (BE); Boone, Luc, B-08020 Oostkamp (BE); Mattelin, Antoon, B-08020 Oostkamp (BE); De-Steur, Hubert, B-09810 Drongen (BE)

(56) Entgegenhaltungen:
- EP-A- 0 057 374
- WO-A-89/04880
- DE-A- 3 026 615
- US-A- 4 247 600
- US-A- 4 444 848
- MOTOROLA TECHNICAL DEVELOPMENTS, Bd.13, 1991, SCHAUMBURG, ILLINOIS US Seiten 129 - 130, XP000259256 D.W. DORINSKI ET AL. 'High temperature thermoplastic substrate having a vacuum deposited solderable electrical conductor'

## Beschreibung

In dem Aufsatz " Integration mit SIL-Technik" in der DE-Z Siemens-Zeitschrift Special · FuE · Herbst 1992, Seiten 4 bis 9, wird die sogenannte SIL-Technik beschrieben, welche anstelle konventioneller gedruckter Schaltungen Spritzgießteile mit integrierten Leiterzügen verwendet. Anstelle der Bezeichnung SIL-Technik ist international die Bezeichnung MID (Moulded Interconnect Device) am gebräuchlichsten. Hochwertige Thermoplaste, die sich zum Spritzgießen von dreidimensionalen, das heißt im Gegensatz zu Leiterplatten, räumlich geformten Teilen eignen, sind die Basis dieser Technik. Derartige Thermoplaste zeichnen sich gegenüber herkömmlichen Substratmaterialien für gedruckte Schaltungen durch bessere mechanische, thermische, chemische, elektrische und umwelttechnische Eigenschaften aus. Zur Herstellung der Leiterzüge auf den dreidimensionalen Kunststoffteilen werden diese zunächst einer Sequenz von Vorbehandlungsschritten unterzogen, die insbesondere das Anätzen, Neutralisieren, Aktivieren, Beschleunigen und zahlreiche Spülbehandlungen umfaßt. Nach diesen Verfahrensschritten werden die Kunststoffteile vollfachig chemisch verkupfert. Der anschließende Aufbau der Leiterzüge kann dann, wie bei der konventionellen Leiterplattenfertigung, subtraktiv, semi-additiv oder volladditiv erfolgen. Bei der Subtraktivtechnik wird das Kunststoffteil vollflachig bis zur gewünschten Kupferdicke galvanisiert, anschließend das Leiterbild mit Ätzresist abgedeckt und die freiliegenden Kupferoberflächen nach der Strukturierung weggeatzt. Bei der Semi-Additivtechnik wird das Kunststoffteil zunächst vollflächig chemisch verkupfert, das Leiterbild danach auf die dünne Kupferschicht aufgebracht und die Leiterbahnen galvanisch verstärkt, worauf die Leiterbahnen dann durch Differenzatzen getrennt werden.

Aus der WO 89 04 880 ist ein Verfahren zur Herstellung von dreidimensionalen Kunststoffteilen mit integrierten Leiterzügen bekannt, bei welchem die Kunststoffteile aus hochtemperaturbeständigen thermoplastischen Formmassen durch Spritzgießen hergestellt und anschließend einer Vorbehandlung unterzogen werden, durch welche eine gute Haftfestigkeit der auf die Kunststoffteile aufzubringenden Leiterzüge gewährleistet werden soll. Diese Vorbehandlung umfaßt das Plasmaatzen der Kunststoffteile in einer Argonatmosphäre oder in einer Argon/Sauerstoffatmosphäre und eine nachfolgende Plasmabehandlung der Kunststoffteile in einer Sauerstoffatmosphäre. Nach dieser Vorbehandlung werden die Kunststoffteile durch Aufdampfen oder durch Sputtern metallisiert, so daß die gewünschten Leiterzüge dann in Semi-Additivtechnik auf den Kunststoffteilen gebildet werden können.

Der im Anspruch 1 angegebenen Erfindung liegt das Problem zugrunde, bei der Herstellung von dreidimensionalen Kunststoffteilen mit integrierten Leiterzügen mit einfachen, wirtschaftlichen und umweltfreundlichen Mitteln eine haftfeste Metallisierung der Kunststoffteile zu ermöglichen.

Bei dem erfindungsgemäßen Verfahren wird die konventionelle naßchemische Vorbehandlung und chemische Verkupferung durch eine kombinierte Anwendung von Plasmaatzen, Plasmabehandlung in einer Edelgasatmosphäre und Sputtern ersetzt. Durch das Plasmaätzen wird die chemisch sehr resistente Oberfläche der spritzgegossenen Kunststoffteile modifiziert. Die Voraussetzungen für eine gute Haftung der durch Sputtern aufgebrachten Metallisierung werden aber erst durch die sich an das Plasmaatzen anschließende Plasmabehandlung in einer Edelgasatmosphäre geschaffen. Obwohl die Vorgänge bei dieser Plasmabehandlung noch nicht restlos geklärt sind, ist zu vermuten, daß es sich hier um einen Reinigungsprozeß handelt, bei welchem Abbauprodukte des Plasmaätzens durch den Beschuß der Oberfläche der Kunststoffteile mit Edelgasionen beseitigt werden. Auf diese Weise können dann nach dem Schältest ermittelte Haftfestigkeiten der nach dem Sputtern galvanisch verstärkten Metallisierung von mindestens 1,0 N/mm erzielt werden. Für die Bildung der Leiterzüge auf den Kunststoffteilen stehen dann sowohl die Subtraktivtechnik, als auch die Semi-Additivtechnik zur Verfügung, wobei die in beiden Fällen erforderliche Ätzbehandlung die Haftfestigkeit der Metallisierung nicht beeinträchtigt. Die erfindungsgemäße Kombination von Behandlungsschritten hat außerdem noch den Vorteil, daß sie zur haftfesten Metallisierung unterschiedlicher Thermoplaste geeignet ist. Schließlich ist noch hervorzuheben, daß mit dem erfindungsgemäßen Verfahren auch ein selektives, zum Beispiel einseitiges Metallisieren der dreidimensionalen Kunststoffteile ermöglicht wird.

Vorteilhafte Ausgestaltungen der Erfindung gehen aus den Unteransprüchen hervor.

Die Deshydratation der thermoplastischen Kunststoffteile durch Wärmebehandlung, die auch als Tempern bezeichnet werden kann, schafft durch den Entzug von Feuchtigkeit optimale Voraussetzungen für die nachfolgenden Schritte zur Metallisierung.

Das Plasmaatzen in einer Sauerstoffatmosphäre gemäß Anspruch 3 ermöglicht im Hinblick auf die erzielbare Haftfestigkeit der Metallisierung bessere Ergebnisse als das Plasmaatzen in anderen oxidierenden Gasen.

Gemäß den Ansprüchen 4 und 5 hat sich sowohl für die Plasmabehandlung, als auch für das Sputtern die Verwendung einer Argonatmosphäre besonders gut bewährt.

Gemäß Anspruch 6 kann beim Sputtern das Kupfer direkt auf den Kunststoffteilen niedergeschlagen werden. Gemäß Anspruch 7 wird demgegenüber beim Sputtern eine Schichtenfolge aus Titan und Kupfer auf den Kunststoffteilen niedergeschlagen, wobei die extrem dünne Titanschicht eine Art Haftschicht bildet.

### Beispiel 1:

Als thermoplastische Formmasse für die Herstellung von dreidimensionalen Kunststoffteilen durch Spritzgießen wurde HT-PA 6/6T verwendet, das beispielsweise unter dem Handelsnamen Ultramid T von der BASF Aktiengesellschaft, Ludwigshafen (DE) bezogen werden kann. Die fertigen Kunststoffteile wurden dann 30 Minuten lang in einer Stickstoffatmosphäre einer Wärmebehandlung bei einer Temperatur von 200° unterzogen. Nach dieser Wärmebehandlung erfolgte in einer Sputteranlage das Plasmaatzen in einer Sauerstoffatmosphäre mit folgenden Parametern:
Behandlungszeit 2' bis 12'
Energiedichte: Rf = 1 bis 4 W/cm²
Druck: 200 m Torr (2.6.10⁻¹ m Bar)
Gasfluß = 200 sccm 0₂
Eletrodenabstand = 50 - 100 mm
RIE-mode

Nach dem Plasmaatzen wurde in der Sputteranlage die Plasmabehandlung in einer Argonatmosphäre mit folgenden Parametern durchgeführt:
Behandlungszeit 2' bis 10'
1,5 10⁻³ m Bar
200 V

Nach der Plasmabehandlung wurde in der Sputteranlage das eigentliche Sputtern in einer Argonatmosphäre vorgenommen, wobei zunächst eine Titanschicht mit einer Stärke von 0,03um und dann eine Kupferschicht mit einer Stärke zwischen 0,1 und 1,0µm abgeschieden wurde. Die Abscheiderate betrug 1µm in 20 Minuten. Die derart hergestellte Metallisierung wurde dann durch galvanische Kupferabscheidung bis zu einer Stärke von 30µm verstärkt. Diese Schicht wurde dann mit einer gleichmäßigen 2µm starken chemisch abgeschiedenen Zinnschicht abgedeckt. Die als Atzresist dienende Zinnschicht wurde dann um die Leiterstrukturen herum mit einem Nd-YAG-LAser verdampft. Anschließend wurde die durch den Laser freigelegte Metallschicht mit naß-chemischen Ätzvorgängen restlos entfernt, wobei sich das erwünschte Leiterbild ergab. Die mit dem Schältest ermittelte Haftfestigkeit betrug mindestens 1 N/mm.

### Beispiel 2:

Abweichend vom Beispiel 1 wurde beim Sputtern unter Verzicht auf die Titanschicht direkt Kupfer in einer Stärke zwischen 0,1 und 1,0µm abgeschieden. Die mit dem Schältest ermittelte Haftfestigkeit betrug auch hier mindestens 1,0 N/mm.

### Beispiel 3:

Abweichend vom Beispiel 1 wurde als thermoplastische Formmasse für die Herstellung der dreidimensionalen Kunststoffteile durch Spritzgießen PEI verwendet, das beispielsweise unter dem Handelsnamen Ultem bei der General Electric Co., Pittsfield, MA 01201 (US), bezogen werden kann. Die mit dem Schältest ermittelte Haftfestigkeit betrug hier mindestens 1,1 N/mm.

### Beispiel 4:

Abweichend vom Beispiel 3 wurde unter Verzicht auf eine Titanschicht direkt Kupfer in einer Stärke zwischen 0,1 und 1,0µm abgeschieden. Die mit dem Schältest ermittelte Haftfestigkeit betrug hier mindestens 1,1 N/mm.

Neben der in den vorstehenden Beispielen beschriebenen Subtraktivtechnik kann für die Herstellung der Leiterzüge auch die Semi-Additivtechnik verwendet werden.

Bei den vorstehend beschriebenen Beispielen wurden das Plasmaatzen, die Plasmabehandlung und das Sputtern in einer gemeinsamen Sputteranlage vorgenommen. Es ist aber auch möglich, diese Schritte in getrennten Anlagen vorzunehmen, wobei die Anlagen dann durch edelgasgespülte Schleusen miteinander verbunden werden.

Das erfindungsgemäße Verfahren zur Herstellung von dreidimensionalen Kunststoffteilen mit integrierten Leiterzügen ist auch für Kunststoffteile auf der Basis folgender Thermoplaste geeignet:
PC/ABS Blends
PPO
ABS
PES
LCP
PPS
PA 6.6, PA 6

Auch bei diesen Thermoplasten ist eine hervorragende Haftung einer durch die erfindungsgemäßen Verfahrensschritte erzeugten Metallisierung gewährleistet.

## Patentansprüche

1. Verfahren zur Herstellung von dreidimensionalen Kunststoffteilen mit integrierten Leiterzügen mit folgenden Schritten:
a)Herstellung der Kunsttoffteile aus thermoplastischen Formmassen durch Spritzgießen,
b)Plasmaätzen der Kunststoffteile in einer oxidierenden Atmosphäre;
c)Plasmabehandlung der Kunststoffteile in einer Edelgasatmosphare;
d)Metallisieren der Kunststoffteile durch Sputtern in einer Edelgasatmosphäre;
e)Bildung von Leiterzügen auf den Kunststoffteilen in Substraktivtechnik oder Semi-Additivtechnik.

2. Verfahren nach Anspruch 1,
**dadurch gekennzeichnet,**
daß die Kunststoffteile vor dem Plasmaatzen zur Deshydratation einer Wärmebehandlung unterzogen werden.

3. Verfahren nach Anspruch 1 oder 2,
**dadurch gekennzeichnet,**
daß das Plasmaatzen der Kunststoffteile in einer Sauerstoffatmosphäre vorgenommen wird.

4. Verfahren nach einem der vorhergehenden Ansprüche,
**dadurch gekennzeichnet,**
daß die Plasmabehandlung in einer Argonatmosphäre vorgenommen wird.

5. Verfahren nach einem der vorhergehenden Ansprüche,
**dadurch gekennzeichnet,**
daß das Sputtern in einer Argonatmosphäre vorgenommen wird.

6. Verfahren nach einem der vorhergehenden Ansprüche,
**dadurch gekennzeichnet,**
daß beim Sputtern Kupfer auf den Kunststoffteilen niedergeschlagen wird.

7. Verfahren nach einem der Ansprüche 1 bis 5,
**dadurch gekennzeichnet,**
daß beim Sputtern eine Schichtenfolge aus Titan und Kupfer auf den Kunststoffteilen niedergeschlagen wird.

## Claims

1. Process for the production of three-dimensional plastic parts with integrated conductive tracks, having the following steps:
a) Producing the plastic parts from thermoplastic moulding compositions by injection moulding,
b) Plasma-etching the plastic parts in an oxidizing atmosphere;
c) Plasma treatment of the plastic parts in a noble-gas atmosphere;
d) Metallizing the plastic parts by sputtering in a noble-gas atmosphere;
e) Forming conductive tracks on the plastic parts using a subtractive technique or semi-additive technique.

2. Process according to Claim 1, characterized in that, in order to dehydrate them, the plastic parts are subjected to a heat-treatment before the plasma etching.

3. Process according to Claim 1 or 2, characterized in that the plasma etching of the plastic parts is carried out in an oxygen atmosphere.

4. Process according to one of the preceding claims, characterized in that the plasma treatment is carried out in an argon atmosphere.

5. Process according to one of the preceding claims, characterized in that the sputtering is carried out in an argon atmosphere.

6. Process according to one of the preceding claims, characterized in that, during the sputtering, copper is deposited on the plastic parts.

7. Process according to one of Claims 1 to 5, characterized in that, during the sputtering, a layer sequence of titanium and copper is deposited on the plastic parts.

## Revendications

1. Procédé de fabrication de pièces tridimensionnelles en matière plastique à lignes conductrices intégrées, comprenant les phases suivantes :
a) fabrication des pièces en matière plastique à partir de matières moulables thermoplastiques selon la technique du moulage par injection ;
b) gravure au plasma des pièces en matière plastique en atmosphère oxydante ;
c) traitement au plasma des pièces en matière plastique en atmosphère de gaz rare ;
d) métallisation des pièces en matière plastique par pulvérisation en atmosphère de gaz rare ;
e) réalisation de lignes conductrices sur les pièces en matière plastique selon la technique soustractive ou la technique semi-additive.

2. Procédé selon la revendication 1, caractérisé en ce que les pièces en matière plastique sont soumises, avant la gravure au plasma, à un traitement thermique en vue d'une déshydratation.

3. Procédé selon la revendication 1 ou 2, caractérisé en ce que la gravure au plasma des pièces en matière plastique est effectuée en atmosphère oxygénée.

4. Procédé selon l'une quelconque des revendications précédentes, caractérisé en ce que le traitement au plasma est effectué en atmosphère d'argon.

5. Procédé selon l'une quelconque des revendications précédentes, caractérisé en ce que la pulvérisation est effectuée en atmosphère d'argon.

6. Procédé selon l'une quelconque des revendications précédentes, caractérisé en ce que lors de la pulvérisation, du cuivre est déposé sur les pièces en matière plastique.

7. Procédé selon l'une des revendications 1 à 5, caractérisé en ce que lors de la pulvérisation, une suite de couches de titane et de cuivre est déposée sur les pièces en matière plastique.
